# EUROPEAN PATENT APPLICATION

(11) **EP 4 797 319 A1**
(43) Date of publication of application: **26.08.2026**
(21) Application number: 24879586.6
(22) Date of filing: 03.10.2024
(51) Int. Cl.: H01L 21/3063

(54) **SUBSTRATE PROCESSING DEVICE**

(30) Priority: 16.10.2023 JP 2023178364
(71) Applicant: SCREEN Holdings Co., Ltd., Kyoto-shi, Kyoto 602-8585 (JP)
(72) Inventor: MORITA, Kosei, Kyoto-shi, Kyoto 602-8585 (JP)
(74) Representative: Kilian Kilian & Partner mbB
(86) International application number: PCT/JP2024/035498
(87) International publication number: WO 2025/084160

(57) **Abstract**

A substrate processing apparatus (1) includes a substrate holder that holds a substrate (9) having a peripheral edge portion (93) on which a metal film (96) is provided on the side of a first main surface (91), an electrode unit (5) that includes a first electrode (51) and a second electrode (52) and in which, when etching is performed, the first electrode is located in the vicinity of the peripheral edge portion on the side of the first main surface, and the second electrode is separated from the first electrode and located in the vicinity of the substrate, a processing-liquid filling unit (6) that fills gaps between the substrate and each of the first and second electrodes with a processing liquid (L1), a power source (50) that applies a voltage between the electrodes to allow etching of a portion of the metal film that is located in the vicinity of the first electrode, and a rotation mechanism that rotates the substrate relative to the electrode unit. The first electrode has a side face including an interest region (516) that has repellency to the processing liquid, the interest region facing radially inward and located in the vicinity of the first main surface.

## Description

### TECHNICAL FIELD

The present invention relates to a substrate processing apparatus.

### CROSS-REFERENCE TO RELATED APPLICATIONS

This application claims priority benefit of Japanese Patent Application No. JP2023-178364 filed in the Japan Patent Office on October 16, 2023, the entire disclosure of which is incorporated herein by reference.

### BACKGROUND ART

A conventional process of manufacturing semiconductor substrates (hereinafter, simply referred to as "substrates") involves various types of processing that are performed on the substrates. For example, in the substrate processing apparatuses disclosed in Japanese Patent Application Laid-Opens No. 2021-158300 (Document 1) and No. 2023-8390 (Document 2), a processing liquid is ejected from a processing liquid supplier to multiple portions at different positions on a substrate where a noble metal film is formed, and the noble metal film on the substrate is etched as a result of the anode coming into contact with the processing liquid on one of the portions as well as the cathode coming into contact with the processing liquid on another portion.

In the case where the electrolyte etching as described in Documents 1 and 2 above is performed on the metal film provided on a peripheral edge portion of the substrate, gaps between the peripheral edge portion and each of the electrodes facing the peripheral edge portion are filled with a processing liquid. Then, a voltage is applied between the electrodes while the substrate is being rotated. In this case, the processing liquid filled in the gaps between the peripheral edge portion and the electrodes may spread radially inward due to surface tension. In the electrolyte etching, etching reactions occur within a range where the processing liquid spreads while being connected to the electrodes (e.g., the cathode). Thus, variations in the spread width of the processing liquid result in variations in the etch width of the metal film.

### SUMMARY OF THE INVENTION

The present invention is intended for a substrate processing apparatus, and it is an object of the present invention to suppress variations in etch width when electrolyte etching is performed on a peripheral edge portion of a substrate.

Aspect 1 of the present invention is a substrate processing apparatus that performs etching on a peripheral edge portion of a substrate. The substrate processing apparatus includes a substrate holder that holds a substrate, the substrate having a disc-like shape with a first main surface and a second main surface and having a peripheral edge portion on which a metal film is provided on a side of the first main surface, an electrode unit that includes a first electrode and a second electrode and in which, when etching is performed, the first electrode is located in a vicinity of the peripheral edge portion on a side of the first main surface, and the second electrode is separated from the first electrode and located in a vicinity of the substrate, a processing-liquid filling unit that fills gaps between the substrate and the first electrode and between the substrate and the second electrode with a processing liquid, a power source that applies a voltage between the first electrode and the second electrode to allow etching of a portion of the metal film that is located in a vicinity of the first electrode, and a rotation mechanism that rotates the substrate relative to the electrode unit to move a portion of the peripheral edge portion where etching is performed in a circumferential direction. The first electrode has a side face including an interest region that has repellency to the processing liquid, the interest region facing radially inward and located in a vicinity of the first main surface.

According to the present invention, it is possible to suppress variations in etch width when electrolyte etching is performed on the peripheral edge portion of the substrate.

Aspect 2 of the present invention is the substrate processing apparatus according to Aspect 1, in which the first electrode includes an electrode body and a liquid-repellent member that covers a region of a side face of the electrode body, the region facing radially inward and located in the vicinity of the first main surface. The interest region is included in a surface of the liquid-repellent member.

Aspect 3 of the present invention is the substrate processing apparatus according to Aspect 1 (or according to Aspect 1 or 2), in which the processing-liquid filling unit includes a processing liquid nozzle that ejects the processing liquid from a radially inner side to a gap between the first electrode and the peripheral edge portion of the substrate.

Aspect 4 of the present invention is the substrate processing apparatus according to any one of Aspects 1 to 3, in which when etching is performed, the first electrode and the second electrode face a target portion that is part of the peripheral edge portion of the substrate, and the processing-liquid filling unit forms a liquid-filled state by ejecting the processing liquid from an ejection port, the liquid-filled state being a state in which the processing liquid is filled in a space among the target portion, the first electrode, and the second electrode.

Aspect 5 of the present invention is the substrate processing apparatus according to Aspect 4, in which the first electrode and the second electrode overlap at least partly when viewed in a direction perpendicular to main surfaces of the substrate.

Aspect 6 of the present invention is the substrate processing apparatus according to Aspect 4 (or according to Aspect 4 or 5) that further includes an electrode movement mechanism that moves the electrode unit in a radial direction.

These and other objects, features, aspects and advantages of the present invention will become more apparent from the following detailed description of the present invention when taken in conjunction with the accompanying drawings.

### BRIEF DESCRIPTION OF DRAWINGS

Fig. 1 is a diagram showing a layout of a substrate processing system.
Fig. 2 is a diagram showing a configuration of a substrate processing apparatus according to a first embodiment.
Fig. 3 is a diagram showing the vicinity of an electrode unit arranged at a processing position.
Fig. 4 is a flowchart showing processing performed on a substrate by the substrate processing apparatus.
Fig. 5 is a diagram showing a gap between a first electrode and a peripheral edge portion of the substrate in enlarged dimensions.
Fig. 6 is a diagram showing in enlarged dimensions a gap between the first electrode and the peripheral edge portion of a substrate in a substrate processing apparatus according to a comparative example.
Fig. 7 is a plan view showing another example of the electrode unit.
Fig. 8 is a sectional view showing another example of the electrode unit.
Fig. 9 is a diagram showing a substrate processing apparatus according to a second embodiment.

### DESCRIPTION OF EMBODIMENTS

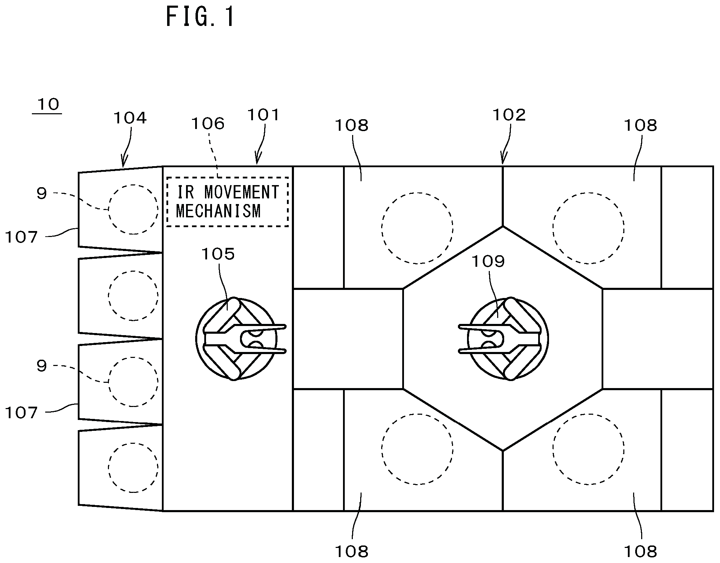

Fig. 1 is a diagram showing a layout of a substrate processing system 10. The substrate processing system 10 is a system that processes disc-like semiconductor substrates 9 (hereinafter, simply referred to as "substrates 9"). The substrate processing system 10 includes an indexer block 101 and a processing block 102 that is bonded to the indexer block 101.

The indexer block 101 includes a carrier holder 104, an indexer robot 105, and an IR movement mechanism 106. The carrier holder 104 holds a plurality of carriers 107 each capable of storing a plurality of substrates 9. The carriers 107 (e.g., FOUPs) are held by the carrier holder 104 while being aligned in a predetermined carrier alignment direction. The IR movement mechanism 106 moves the indexer robot 105 in the carrier alignment direction. The indexer robot 105 performs a transport-out operation of transporting the substrates 9 out of the carriers 107 and a transport-in operation of transporting the substrates 9 into the carriers 107. The substrates 9 are transported in a horizontal position by the indexer robot 105.

The processing block 102 includes a plurality of (e.g., four or more) processing units 108 that process the substrates 9, and a center robot 109. The processing units 108 are arranged to surround the center robot 109 in plan view. The processing units 108 perform a variety of processing on the substrates 9. A substrate processing apparatus described later corresponds to one of the processing units 108. The center robot 109 transfers the substrates 9 to and from the indexer robot 105. The center robot 109 also performs a transport-in operation of transporting the substrates 9 into the processing units 108 and a transport-out operation of transporting the substrates 9 out of the processing units 108. The center robot 109 also transports the substrates 9 among the processing units 108. The substrates 9 are transported in a horizontal position by the center robot 109.

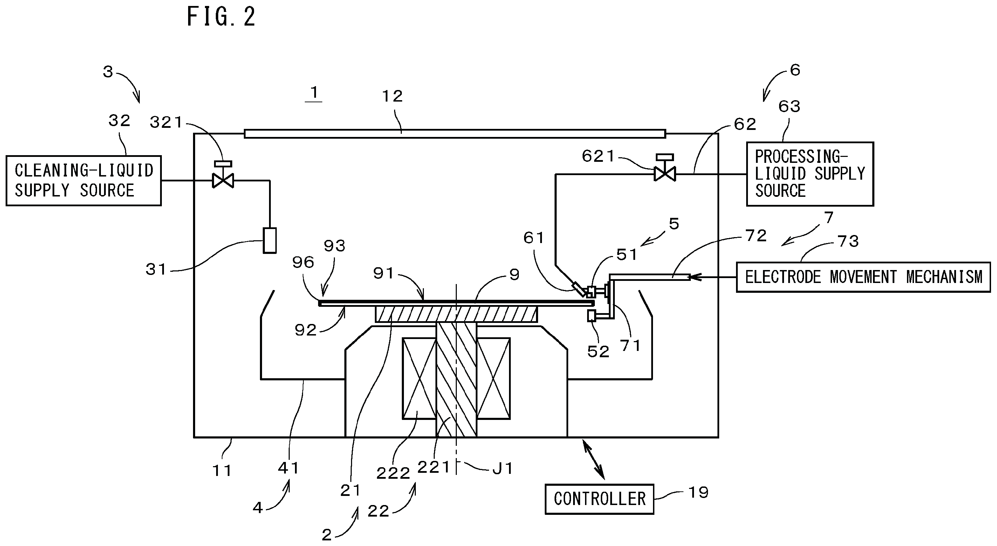

Fig. 2 is a diagram showing a configuration of a substrate processing apparatus 1 according to a first embodiment. Fig. 2 shows part of the configuration of the substrate processing apparatus 1 in cross section in a plane that includes a predetermined central axis J1. The substrate processing apparatus 1 is a single-wafer processing apparatus that processes the substrates 9 one by one, and performs electrolytic etching on a peripheral edge portion 93 of a disc-like substrate 9. The peripheral edge portion 93 of the substrate 9 includes an edge end face (apex), bevel portions, and portions located in the vicinity of the bevel portions on a first main surface 91 and a second main surface 92, which will be described later.

The substrate processing apparatus 1 includes a spin chuck 2, a cleaning-liquid supplier 3, a cup part 4, an electrode unit 5, a processing-liquid filling unit 6, an electrode mover 7, a housing 11, and a controller 19. The spin chuck 2, part of the cleaning-liquid supplier 3, the cup part 4, the electrode unit 5, part of the processing-liquid filling unit 6, and part of the electrode mover 7 are housed in the internal space of the housing 11. The canopy portion of the housing 11 is provided with an airflow former 12 that supplies a gas to the internal space to form an airflow flowing downward (so-called a downflow). As the airflow former 12, for example, an FFU (fan filter unit) is used. The controller 19 is arranged outside the housing 11 and controls each constituent element of the substrate processing apparatus 1. For example, the controller 19 is realized by a computer executing a predetermined program, the computer including, for example, a CPU and memory. Part or the whole of the controller 19 may be realized by, for example, a programmable logic controller (PLC).

The spin chuck 2 shown in Fig. 2 includes a chuck part 21 and a rotation mechanism 22. The chuck part 21 serves as a substrate holder that has an approximately disc-like shape centered on the central axis J1 extending approximately in parallel with the up-down direction, and that holds a substrate 9 in a horizontal position from the underside. The chuck part 21 is, for example, a vacuum chuck that contacts and adsorbs on a central portion of the lower main surface 92 of the substrate 9. Typically, the chuck part 21 has a smaller diameter than the substrate 9. The center of the substrate 9 on the chuck part 21 approximately coincides with the central axis J1. In the following description, when the substrate 9 is held in a horizontal position on the chuck part 21, the main surface 92 facing downward is referred to as the "second main surface 92", and the main surface 91 facing upward is referred to as the "first main surface 91". A radial direction and a circumferential direction that are centered on the central axis J1 are simply referred to as the "radial direction" and the "circumferential direction". The radial direction is also the radial direction of the substrate 9, and the circumferential direction is also the circumferential direction of the substrate 9.

A metal film 96 to be processed by the substrate processing apparatus 1 is provided on the peripheral edge portion 93 of the substrate 9 on the side of the first main surface 91. The metal film 96 has a thickness of, for example, several tens nanometers. The metal film 96 is provided on the entire or part of the peripheral edge portion 93. On the side of the first main surface 91, the metal film 96 may only need to exist at least on the peripheral edge portion 93, but it may also exist, in addition to on the peripheral edge portion 93, on a region that is located inward of the peripheral edge portion 93. The metal film 96 may spread approximately across the first main surface 91 of the substrate 9. In addition to on the side of the first main surface 91, the metal film 96 may also exist on the side of the second main surface 92. In Fig. 2, the metal film 96 is indicated by the thick line. The metal film 96 contains, for example, ruthenium (Ru). Other than a film made from ruthenium alone, the metal film 96 may also be a film that contains a compound of ruthenium. The metal film 96 may also be a film that contains a metal other than ruthenium. In the present embodiment, it is assumed that the metal film 96 contains ruthenium.

The rotation mechanism 22 is arranged below the chuck part 21. The rotation mechanism 22 rotates the substrate 9 together with the chuck part 21 about the central axis J1. The rotation mechanism 22 includes a shaft 221 and a motor 222. The shaft 221 is an approximately columnar or cylindrical member centered on the central axis J1. The shaft 221 extends in the up-down direction and is connected to a central portion of the lower surface of the chuck part 21. The motor 222 is an electric rotary motor that rotates the shaft 221. The rotation mechanism 22 may also be a motor having a different structure (e.g., a hollow motor).

The cleaning-liquid supplier 3 includes a cleaning-liquid nozzle 31 and a cleaning-liquid supply source 32. The cleaning-liquid nozzle 31 is supported by a nozzle movement mechanism, which is not shown. The nozzle movement mechanism includes, for example, a motor and a ball screw and moves the cleaning-liquid nozzle 31 approximately horizontally between a supply position located above the substrate 9 and a retracted position located radially outward of the substrate 9. The cleaning-liquid nozzle 31 is connected to the cleaning-liquid supply source 32 through a cleaning liquid line provided with a valve 321. The cleaning-liquid supply source 32 supplies the cleaning liquid to the cleaning-liquid nozzle 31. The cleaning liquid is, for example, pure water such as DIW (deionized water). The cleaning liquid may also be an organic solvent such as IPA or any other type of liquid.

The cup part 4 includes a cup 41 and a cup elevating mechanism, which is not shown. The cup 41 is a ring-shaped member centered on the central axis J1. The cup 41 is arranged around the entire circumferences of the substrate 9 and the chuck part 21 and covers the sides and bottoms of the substrate 9 and the chuck part 21. The cup 41 is a liquid-receiving container that receives a liquid scattered from the rotating substrate 9 to the surroundings. The inner surface of the cup 41 is formed of, for example, a water-repellent material. The cup 41 remains stationary in the circumferential direction, regardless of whether the substrate 9 is rotating or remains stationary. The bottom of the cup 41 is provided with a drain port (not shown) through which the liquid received by the cup 41 is discharged to the outside of the housing 11.

The cup elevating mechanism moves the cup 41 relative to the chuck part 21 in the up-down direction. For example, the cup elevating mechanism includes a motor or an air cylinder as a driving source. The cup elevating mechanism is capable of moving the cup 41 in the up-down direction between a processing position that is a position located around the substrate 9 shown in Fig. 2 and a retracted position that is located downward of the processing position. The cup part 4 may include a plurality of cups 41 stacked one above another in the radial direction. In the case where the cup part 4 includes a plurality of cups 41, each cup 41 is independently movable in the up-down direction and is used to receive a liquid by switching among the cups 41 depending on the type of the liquid scattered from the substrate 9.

The electrode unit 5 includes a first electrode 51 and a second electrode 52. The first electrode 51 and the second electrode 52 each have a rod-like or columnar shape extending in the up-down direction. The first electrode 51 and the second electrode 52 are separated from each other in the up-down direction. As described later, the electrode unit 5 is supported by the electrode mover 7, and is arranged at a processing position facing part of the peripheral edge portion 93 during etching of the peripheral edge portion 93. When the electrode unit 5 is arranged at the processing position, the first electrode 51 is located on the side of the first main surface 91 of the substrate 9, and the second electrode 52 is located on the side of the second main surface 92 of the substrate 9. Since the etching of the metal film 96 is performed on a portion of the peripheral edge portion 93 that faces the electrode unit 5, this portion is hereinafter referred to as the "target portion."

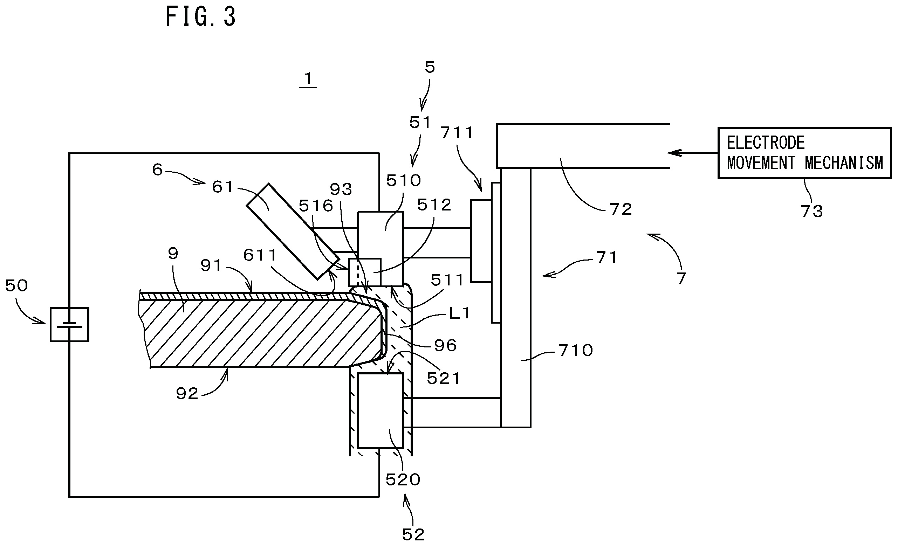

Fig. 3 is a diagram showing the vicinity of the electrode unit 5 arranged at the processing position. Fig. 3 shows the substrate 9 in cross section (in cross section in a plane that includes the central axis J1). The first electrode 51 includes an electrode body 510 and a liquid-repellent member 512. The second electrode 52 includes an electrode body 520. Each of the electrode bodies 510 and 520 has a rod-like or columnar shape extending in the up-down direction. The diameter of each of the electrode bodies 510 and 520 is, for example, greater than or equal to 2 mm and less than or equal to 20 mm, and preferably less than or equal to 4 mm. In the present embodiment, the electrode body 510 of the first electrode 51 and the electrode body 520 of the second electrode 52 are almost of the same size and arranged at the same position when viewed in the up-down direction. That is, the electrode body 510 overlaps approximately entirely with the electrode body 520 when viewed in plan view. Examples of the materials for each of the electrode bodies 510 and 520 include platinum (Pt) and glassy carbon (glass carbon). As the materials for the electrode bodies 510 and 520, other conductive materials that allow appropriate execution of etching, which will be described later, may be used.

With the electrode unit 5 arranged at the processing position, a downward face 511 of the electrode body 510 of the first electrode 51 is approximately parallel to the first main surface 91 of the substrate 9 and faces the peripheral edge portion 93 on the side of the first main surface 91 of the substrate 9. An upward face 521 of the electrode body 520 of the second electrode 52 is approximately parallel to the second main surface 92 of the substrate 9 and faces the peripheral edge portion 93 on the side of the second main surface 92 of the substrate 9. In the following description, the face 511 of the electrode body 510 and the face 521 of the electrode body 520 are referred to as the "opposing faces 511 and 521". In the example shown in Fig. 3, the opposing faces 511 and 521 are both circular.

The electrode body 510 of the first electrode 51 and the electrode body 520 of the second electrode 52 are electrically connected to a power source 50. When etching is performed on the peripheral edge portion 93, as described later, the processing-liquid filling unit 6 fills the space among the target portion of the peripheral edge portion 93, the electrode body 510, and the electrode body 520 with a processing liquid L1, and a predetermined voltage is applied between the electrode body 510 and the electrode body 520.

The liquid-repellent member 512 of the first electrode 51 covers the side face of the electrode body 510 (the face approximately perpendicular to the main surfaces 91 and 92 of the substrate 9). In the example shown in Fig. 3, the liquid-repellent member 512 has an approximately semi-circular cylindrical shape, and covers a region of the side face of the electrode body 510 that faces radially inward and that is located in the vicinity of the first main surface 91 of the substrate 9. Here, on the cylindrical side face of the electrode body 510, the "region that faces radially inward" refers to, for example, a region within a range of 90° (preferably within a range of 120° and more preferably within a range of 180°) centered on a direction extending from the center of the electrode body 510 toward the central axis J1. On the side face of the electrode body 510, the "region that is located in the vicinity of the first main surface 91" refers to, for example, a region that is located within 1 mm (preferably within 2 mm and more preferably within 3 mm) from the opposing face 511. The definitions of the "region that faces radially inward" and the "region that is located in the vicinity of the first main surface 9" also apply to an interest region 516, which will be described later.

In the up-down direction, the end face of the liquid-repellent member 512 on the side of the substrate 9 is arranged at approximately the same position as the opposing face 511 of the electrode body 510, or arranged between the opposing face 511 and the substrate 9. There are no particular limitations on the size of the liquid-repellent member 512 as long as it can cover a region of the side face of the electrode body 510 that faces radially inward and that is located in the vicinity of the first main surface 91. In one example, the liquid-repellent member 512 covers a range of 180° on the side face of the electrode body 510. The height of the liquid-repellent member 512 in the up-down direction is in the range of, for example, 5 mm to 20 mm, and the thickness of the liquid-repellent member 512 is in the range of, for example, 0.5 mm to 1.5 mm. The liquid-repellent member 512 and the electrode body 510 are bonded using an arbitrary technique such as adhesive bonding.

The liquid-repellent member 512 is formed of a material having repellency (hydrophobic properties) to the processing liquid L1. One example of the material is a fluorocarbon resin such as Teflon (registered trademark). The material may also be a resin other than a fluorocarbon resin, or may also be any type of materials other than a resin. The liquid-repellent member 512 has higher liquid repellency than the electrode body 510 of the first electrode 51. The liquid repellency can be evaluated by, for example, measuring the angle of contact with the processing liquid L1. The angle of contact is measured by preparing a sample with a flat surface that is formed of same material and is in the same surface state as the liquid-repellent member 512, and dropping the processing liquid L1 on the flat surface. The same also applies to the electrode body 510. The angle of contact of the liquid-repellent member 512 is greater than the angle of contact of the electrode body 510.

In the first electrode 51 including the electrode body 510 and the liquid-repellent member 512, its side face exposed to and facing outside includes a portion that corresponds to the side face of the electrode body 510 and a portion that corresponds to the surface of the liquid-repellent member 512 (the surface along the side face of the electrode body 510). On the side face of the first electrode 51, a region 516 that faces radially inward and that is located in the vicinity of the first main surface 91 (hereinafter, referred to as the "interest region 516") is the surface of the liquid-repellent member 512. That is, in the interest region 516, the liquid-repellent member 512 is layered, and the interest region 516 has repellency to the processing liquid L1. In the case where the processing liquid L1 is an aqueous solution, the interest region 516 of the first electrode 51 has water repellency because the liquid-repellent member 512 is a water-repellent member with water-repellency (hydrophobic properties). Note that, for the second electrode 52, the surrounding of the electrode body 520 may be covered with another member.

As shown in Fig. 2, the processing-liquid filling unit 6 includes a processing liquid nozzle 61, a processing liquid line 62, and a processing-liquid supply source 63. The processing liquid nozzle 61 is supported together with the electrode unit 5 by the electrode mover 7. The processing liquid nozzle 61 is connected to the processing-liquid supply source 63 through the processing liquid line 62. The processing-liquid supply source 63 supplies the processing liquid L1 to the processing liquid nozzle 61. The processing liquid line 62 is provided with a valve 621. As shown in Fig. 3, the processing liquid nozzle 61 is arranged radially inward of the first electrode 51 on the side of the first main surface 91 of the substrate 9. The processing liquid nozzle 61 is inclined relative to the up-down direction so that its lower end provided with an ejection port 611 is located radially outward of its upper end. The ejection port 611 opens toward the gap between the first electrode 51 and the peripheral edge portion 93. During etching of the peripheral edge portion 93, the processing liquid L1 is ejected from the ejection port 611 toward the gap.

The processing liquid L1 is typically an electrolytic solution and is, for example, an aqueous solution that contains, for example, hydrogen chloride (HCl) or ammonium chloride (NH₄Cl) as a solute. The concentration of the solute is, for example, higher than or equal to 5 wt% and preferably higher than or equal to 10 wt%. There are no particular limitations on the upper limit for the concentration of the solute, but the upper limit is, for example, 25 wt%. The electrolytic solution may contain an additive or the like. The electrolytic solution may also be nonaqueous.

As shown in Fig. 2, the electrode mover 7 includes a supporter 71, an arm part 72, and an electrode movement mechanism 73. The supporter 71 supports the processing liquid nozzle 61, the first electrode 51, and the second electrode 52. To be more specific, the supporter 71 includes a supporter body 710 and an auxiliary movement mechanism 711 as shown in Fig. 3. The second electrode 52 is fixedly attached to the support body 710. The auxiliary movement mechanism 711 includes a fixed unit and a mobile unit. The fixed unit is fixedly attached to the supporter body 710, and the mobile unit is movable relative to the fixed unit in the up-down direction. The mobile unit is fixedly attached to the processing liquid nozzle 61 and the first electrode 51. In this way, the supporter 71 supports the processing liquid nozzle 61, the first electrode 51, and the second electrode 52 while allowing the processing liquid nozzle 61 and the first electrode 51 to be movable in the up-down direction relative to the second electrode 52. The auxiliary movement mechanism 711 includes, for example, a motor and a ball screw. The auxiliary movement mechanism 711 may be realized by, for example, a linear motor.

The arm part 72 is a member that extends in the radial direction. One end of the arm part 72 is attached to the supporter 71, and the other end is supported by the electrode movement mechanism 73. The electrode movement mechanism 73 includes, for example, a motor and a ball screw and is capable of moving the arm part 72 in the radial direction (the longitudinal direction of the arm part 72) and the up-down direction. In other words, the electrode movement mechanism 73 moves the electrode unit 5 and the processing liquid nozzle 61 in the radial direction and the up-down direction. During etching of the peripheral edge portion 93, the electrode movement mechanism 73 arranges the electrode unit 5 together with the processing liquid nozzle 61 at the processing position facing part (i.e., the target portion) of the peripheral edge portion 93 of the substrate 9. When the etching is completed, the electrode unit 5 and the processing liquid nozzle 61 are arranged at the retracted position located radially outward of the substrate 9. The electrode movement mechanism 73 may be realized by, for example, a linear motor.

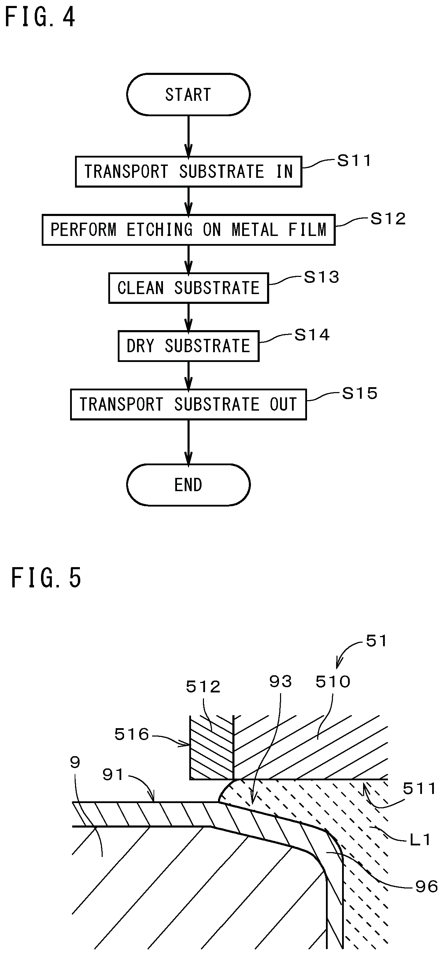

Next, a procedure for processing performed on the substrate 9 by the substrate processing apparatus 1 is described with reference to Fig. 4. In the processing performed on the substrate 9, each constituent element is controlled by the controller 19 shown in Fig. 2. Firstly, the substrate 9 with the metal film 96 formed thereon is transported into the substrate processing apparatus 1 and placed on the chuck part 21 (step S11). The substrate 9 is held on the chuck part 21 by vacuum suction. At this time, the electrode unit 5 and the processing liquid nozzle 61 are arranged at the retracted position that do not inhibit the transport of the substrate 9. The same also applies to the cleaning-liquid nozzle 31. Note that, after the transport-in of the substrate 9, cleaning processing (pre-cleaning) may be performed on the substrate 9 in the same manner as in step S13, which will be described later.

When the substrate 9 is held, the electrode movement mechanism 73 moves the arm part 72 so that the electrode unit 5 is arranged together with the processing liquid nozzle 61 at the processing position. Thus, as shown in Fig. 3, the electrode unit 5 and the processing liquid nozzle 61 face the target portion of the peripheral edge portion 93 of the substrate 9. To be more specific, the first electrode 51 is located in the vicinity of the target portion on the side of the first main surface 91, and the second electrode 52 is located in the vicinity of the target portion on the side of the second main surface 92. The processing liquid nozzle 61 is arranged radially inward of the first electrode 51. At this time, the auxiliary movement mechanism 711 adjusts the distances between the substrate 9 (the peripheral edge portion 93 of the substrate 9) and each of the opposing face 511 of the first electrode 51 and the opposing face 521 of the second electrode 52 to become less than or equal to several millimeters. When the electrode unit 5 and so on are arranged at the processing position, the rotation mechanism 22 starts to rotate the substrate 9 at a predetermined rotational speed.

Then, the valve 621 in the processing liquid line 62 shown in Fig. 2 is opened, so that the processing liquid L1 is ejected from the ejection port 611 of the processing liquid nozzle 61 toward the gap between the first electrode 51 and the peripheral edge portion 93. As shown in Fig. 3, the processing liquid L1 enters and fills the gap between the first electrode 51 and the peripheral edge portion 93. Part of the processing liquid L1 may flow radially outward around this gap. The processing liquid L1 also flows around to the side of the second main surface 92 of the peripheral edge portion 93 and fills the gap between the second electrode 52 and the peripheral edge portion 93 via capillary action. This produces a liquid-filled state in which the processing liquid L1 is filled in the space among the target portion of the peripheral edge portion 93, the first electrode 51, and the second electrode 52. In the liquid-filled state, the processing liquid L1 is continuous among the target portion, the first electrode 51, and the second electrode 52 without interruption. An excess amount of the processing liquid L1 flows downward and is collected by the cup 41.

In the formation of the liquid-filled state, the processing liquid nozzle 61 ejects the processing liquid L1 from the radially inner side toward the gap between the first electrode 51 and the peripheral edge portion 93. Thus, on the side face of the first electrode 51, the processing liquid L1 also collides with the interest region 516 that faces radially inward and that is located in the vicinity of the first main surface 91. Since the interest region 516 has repellency to the processing liquid L1, the processing liquid L1 flows down without remaining on the interest region 516. As shown in Fig. 5, on the opposing face 511 of the electrode body 510, a surface of the processing liquid L1 is formed from the vicinity of the boundary with the liquid-repellent member 512 toward the first main surface 91 of the substrate 9. Therefore, on the first main surface 91, the processing liquid L1 hardly spreads radially inward from the gap between the first electrode 51 and the substrate 9. On the second main surface 92 of the substrate 9, the processing liquid L1 may slightly spread radially inward from the gap between the second electrode 52 and the substrate 9. As long as the liquid-filled state is maintained, the processing liquid L1 may be supplied either continuously or intermittently from the processing liquid nozzle 61 toward the peripheral edge portion 93.

Then, the power source 50 applies a predetermined voltage between the first electrode 51 and the second electrode 52. In the example shown in Fig. 3, a higher potential is applied to the second electrode 52 than to the first electrode 51, so that the first electrode 51 serves as a cathode and the second electrode 52 serves as an anode. The application of the voltage to the electrode unit 5 causes the metal film 96 to be etched on the target portion of the peripheral edge portion 93 (step S12). In actuality, a portion of the metal film 96 that is located in close proximity to the cathode is preferentially etched. The reason why the metal film 96 is etched is not clear, but for example, it is presumed that the following chemical reactions occur between the first electrode 51 and the second electrode 52.

On the opposing face 511 of the first electrode 51, a chemical reaction expressed by Expression (1) occurs.

2H⁺ + 2e⁻→H₂ ... (1)

On the metal film 96 on the side of the first electrode 51, chemical reactions expressed by Expressions (2), (3), and (4) occur.

Ru→Ru³⁺ + 3e⁻ ... (2)

2Cl⁻→Cl₂ + 2e⁻ ... (3)

2H₂O→O₂ + 4H⁺ + 4e⁻ ... (4)

Accordingly, the metal film 96 dissolves in the processing liquid L1.

On the metal film 96 on the side of the second electrode 52, a chemical reaction expressed by Expression (5) occurs.

2H⁺ + 2e⁻→H₂ ... (5)

On the opposing face 521 of the second electrode 52, chemical reactions expressed by Expressions (6) and (7) occur.

2Cl⁻→Cl₂ + 2e⁻ ... (6)

2H₂O→O₂ + 4H⁺ + 4e⁻ ... (7)

In experiments in which the processing liquid is filled in the space among the metal film, the first electrode, and the second electrode, and a voltage is applied to the processing liquid via the first electrode and the second electrode, it is confirmed that the metal film has been actually etched.

As described previously, the substrate 9 rotates relative to the electrode unit 5, and the target portion of the peripheral edge portion 93 moves in the circumferential direction relative to the substrate 9. Thus, the metal film 96 is etched around the entire circumference of the peripheral edge portion 93. An image capturer not shown is provided above the peripheral edge portion 93 of the substrate 9 to acquire images of the peripheral edge portion 93 around the entire circumference. The images of the peripheral edge portion 93 are input to the controller 19 to check the state of the peripheral edge portion 93. Specifically, it is checked whether the metal film 96 has been removed from the entire peripheral edge portion 93. The presence or absence of the metal film 96 on the peripheral edge portion 93 can be acquired using a known inspection algorithm. The presence or absence of the metal film 96 may also be checked using any other technique. For example, the presence or absence of the metal film 96 may be detected by measuring current flowing between the second electrode 52 and the first electrode 51.

When the metal film 96 has been removed from the entire peripheral edge portion 93, the application of the voltage between the electrodes 51 and 52 and the ejection of the processing liquid L1 from the processing liquid nozzle 61 are stopped, and the etching terminates. Thereafter, the electrode movement mechanism 73 moves the arm part 72 radially outward, so that the electrode unit 5 and the processing liquid nozzle 61 are moved away from the peripheral edge portion 93 to the retracted position. The cleaning liquid nozzle 31 is also arranged at the supply position above the substrate 9. Then, the cleaning liquid is supplied from the cleaning liquid nozzle 31 toward a central portion of the first main surface 91 of the substrate 9. The cleaning liquid spreads across the entire first main surface 91 of the substrate 9, and cleaning processing is performed to rinse the processing liquid L1 or the like adhering to the peripheral edge portion 93 of the substrate 9 (step S13). The cleaning liquid is scattered radially outward from the peripheral edge portion 93 of the substrate 9 by centrifugal force caused by the rotation of the substrate 9, and is collected by the cup 41. Note that the cleaning liquid nozzle 31 may eject the cleaning liquid toward the peripheral edge portion 93. As another alternative, another nozzle may be provided for ejecting a cleaning liquid onto the peripheral edge portion 93 on the side of the second main surface 92.

After the cleaning processing is performed on the substrate 9 for a predetermined amount of time, the supply of the cleaning liquid from the cleaning-liquid nozzle 31 to the substrate 9 is stopped. Then, the rotational speed of the substrate 9 is increased so as to shake off and remove the cleaning liquid off the substrate 9. That is, dry processing is performed on the substrate 9 (step S14). When the dry processing performed on the substrate 9 is completed, the rotation of the substrate 9 is stopped. Thereafter, the substrate 9 is transported out of the substrate processing apparatus 1 (step S15). Through the processing described above, the processing performed on the substrate 9 by the substrate processing apparatus 1 is completed.

As described above, the substrate processing apparatus 1 shown in Fig. 2 includes the substrate holder (in the above-described example, the chuck part 21), the electrode unit 5, the processing-liquid filling unit 6, the power source 50, and the rotation mechanism 22. The substrate holder holds a disc-like substrate 9 having the first main surface 91 and the second main surface 92. The metal film 96 is provided on the peripheral edge portion 93 of the substrate 9 on the side of the first main surface 91. The electrode unit 5 includes the first electrode 51 and the second electrode 52. During etching, the first electrode 51 is located in the vicinity of the peripheral edge portion 93 on the side of the first main surface 91, and the second electrode 52 is separated from the first electrode 51 and located in the vicinity of the substrate 9. The processing-liquid filling unit 6 fills the gaps between the substrate 9 and each of the first electrode 51 and the second electrode 52 with the processing liquid L1. The power source 50 applies a voltage between the first electrode 51 and the second electrode 52 to allow etching of a portion of the metal film 96 that is located in the vicinity of the first electrode 51. The rotation mechanism 22 rotates the substrate 9 relative to the electrode unit 5 to move a portion of the peripheral edge portion 93 where etching is performed in the circumferential direction. Then, the liquid-repellent member 512 is provided on the first electrode 51, so that on the side face of the first electrode 51, the interest region 516 facing radially inward and located in the vicinity of the first main surface 91 has repellency to the processing liquid L1.

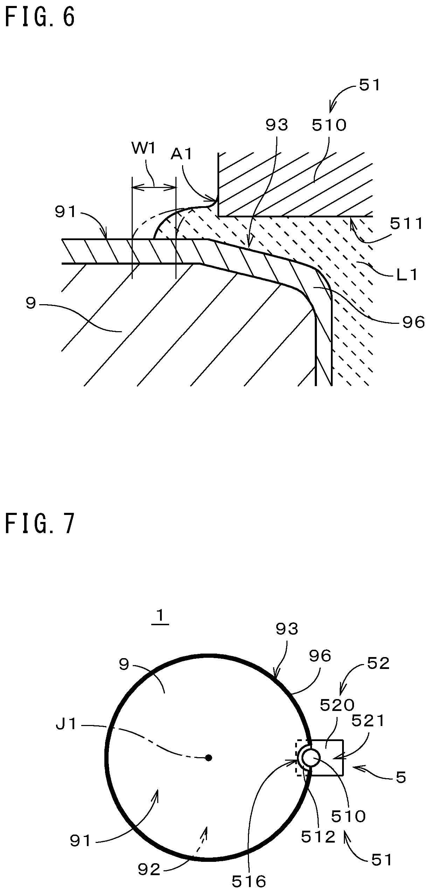

Here, a substrate processing apparatus according to a comparative example is considered, in which the liquid-repellent member 512 of the first electrode 51 is not provided. In the substrate processing apparatus according to the comparative example as shown in Fig. 6, on the side face of the first electrode 51, a region A1 that faces radially inward and that is located in the vicinity of the first main surface 91 is the surface of the electrode body 510. Since the surface of the electrode body 510 exhibits relatively high wettability with the processing liquid L1, the accumulation of the processing liquid L1 is likely to occur on the region A1. This liquid accumulation causes the processing liquid L1 filled in the gap between the first electrode 51 and the peripheral edge portion 93 to spread radially inward due to surface tension. In actuality, the spread width of the processing liquid L1 becomes uneven depending on the degree of liquid accumulation and any other factor. Thus, variations occur in the radial width of the region of the peripheral edge portion 93 where the metal film 96 is etched, i.e., variations occur in etch width (cut width). In Fig. 6, the width of variations in the radially inward position of the region where the metal film 96 is etched is indicated by the arrow W1.

In contrast, in the substrate processing apparatus 1 described above, since the interest region 516 of the first electrode 51 has repellency to the processing liquid L1, it is possible to prevent the occurrence of liquid accumulation on the interest region 516 as shown in Fig. 5. This suppresses radially inward spread of the processing liquid L1 from the gap between the first electrode 51 and the peripheral edge portion 93 and consequently suppresses variations in the etch width of the metal film 96.

In the substrate processing apparatus 1, the liquid-repellent member 512 may be omitted, and the side face of the electrode body 510 may have liquid repellency. For example, with the opposing face 511 of the electrode body 510 masked, liquid-repellent treatment is performed on the side face of the electrode body 510. In this case, the liquid repellency of the side face of the electrode body 510 can be improved compared to before the liquid-repellent treatment. This realizes the first electrode 51 that has liquid repellency on the interest region 516 while omitting the liquid-repellent member 512.

Meanwhile, in order to easily realize the interest region 516 having liquid repellency, it is preferable that the first electrode 51 includes the electrode body 510 and the liquid-repellent member 512, and on the side face of the electrode body 510, the liquid-repellent member 512 covers a region that faces radially inward and that is located in the vicinity of the first main surface 91. In this case, the interest region 516 described above corresponds to a region on the surface of the liquid-repellent member 512. That is, the interest region 516 is included in the surface of the liquid-repellent member 512. The liquid-repellent member 512 may cover the entire circumference of the electrode body 510, but in order to reduce the manufacturing cost of the substrate processing apparatus 1, it is preferable that the liquid-repellent member 512 is not provided on a radially outward portion of the side face of the electrode body 510.

More preferably, the substrate processing apparatus 1 further includes the electrode movement mechanism 73 that moves the electrode unit 5 in the radial direction. This enables easily changing the etch width of the metal film 96. Depending on the design of the substrate processing apparatus 1, the positions of the electrode unit 5 and the processing liquid nozzle 61 inside the housing 11 may be fixed, and the electrode movement mechanism 73 may be omitted.

Meanwhile, in the etching of the metal film 96 on the peripheral edge portion 93, a portion of the metal film 96 that is located in close proximity to the cathode is preferentially removed as described previously. In other words, a certain amount of time is required to remove a portion of the metal film 96 that is located in close proximity to the anode. Thus, depending on the position where the metal film 96 adheres to, a prolonged period of time may be required to remove the entire metal film 96 existing on the peripheral edge portion 93.

Next is a description about a preferable technique for efficiently removing the entire metal film 96 existing on the peripheral edge portion 93. In the etching of the metal film 96 on the peripheral edge portion 93, when a portion of the metal film 96 that is located in close proximity to the first electrode 51 serving as the cathode has been removed, the auxiliary movement mechanism 711 shown in Fig. 3 slightly moves the first electrode 51 toward the substrate 9. This reduces the distance between the opposing face 511 of the first electrode 51 and the metal film 96 remaining on the peripheral edge portion 93 and accordingly shortens the time required to remove the entire metal film 96 existing on the peripheral edge portion 93.

At this time, the auxiliary movement mechanism 711 moves the processing liquid nozzle 61 together with the first electrode 51. Thus, even if the first electrode 51 is brought closer to the remaining metal film 96, it is possible to supply the processing liquid L1 to an appropriate position between the first electrode 51 and the substrate 9. Depending on the design of the substrate processing apparatus 1, the auxiliary movement mechanism 711 may move only the first electrode 51. The timing when the auxiliary movement mechanism 711 moves the first electrode 51 closer to the substrate 9 is, for example, determined based on the images of the peripheral edge portion 93 acquired by the imaging capturer. This timing may also be determined based on the current flowing between the second electrode 52 and the first electrode 51, or may be determined in advance.

Instead of or along with the movement of the first electrode 51 by the auxiliary movement mechanism 711, the power source 50 may increase the voltage applied between the first electrode 51 and the second electrode 52. This accelerates the removal of a portion of the metal film 96 that is located away from the first electrode 51. Moreover, after removal of a portion of the metal film 96 that is located in close proximity to the first electrode 51 serving as the cathode, the power source 50 may invert the cathode and the anode (invert the polarities of the first electrode 51 and the second electrode 52). This makes the first electrode 51 facing the first main surface 91 serve as the anode and makes the second electrode 52 facing the second main surface 92 serve as the cathode. In other words, the electrode 52 becomes the first electrode where the metal film 96 is etched in the vicinity thereof, and the electrode 51 becomes the second electrode. As a result, it becomes possible to accelerate the etching of a portion of the metal film 96 that is located in close proximity to the electrode 52 serving as the first electrode and to shorten the time required to remove the entire metal film 96 existing on the peripheral edge portion 93 (i.e., shorten the etching time). The above-described technique for shortening the etching time may also be adopted in other examples.

Fig. 7 is a plan view showing another example of the electrode unit 5. In Fig. 7, the processing liquid nozzle 61 is not shown. In the electrode unit 5 shown in Fig. 7, the second electrode 52 (the electrode body 520 thereof) located on the side of the second main surface 92 of the substrate 9 has a rectangular plate-like shape. The upward face of the second electrode 52 corresponds to the opposing face 521 facing the substrate 9 and is approximately parallel to the second main surface 92 of the substrate 9. The opposing face 521 of the second electrode 52 is larger than the opposing face 511 of the first electrode 51 (see the opposing face 511 of the electrode body 510 shown in Fig. 3). The area of the opposing face 521 is, for example, twice or more of the area of the opposing face 511 and preferably three times or more. There are no particular limitations on the upper limit for the area of the opposing face 521. However, an excessive increase in the area of the opposing face 521 will increase the weight of the second electrode 52, so that the area of the opposing face 521 is, for example, ten times or less of the area of the opposing face 511. When viewed in plan view, the first electrode 51 overlaps entirely with the second electrode 52.

As described above, the opposing face 521 of the second electrode 52 located on the side of the second main surface 92 of the substrate 9 is larger than the opposing face 511 of the first electrode 51 located on the side of the first main surface 91 of the substrate 9. This improves retention of the processing liquid L1 on the second electrode 52. As a result, it becomes possible to easily maintain the liquid-filled state in which the processing liquid L1 is filled in the space among the target portion of the peripheral edge portion 93, the first electrode 51, and the second electrode 52. The large opposing face 521 of the second electrode 52 serving as the anode also accelerates reduction reactions occurring by the opposing face 521 as compared to the electrode unit 5 shown in Fig. 3. This also accelerates oxidation reactions occurring by the opposing face 511 of the first electrode 51 and achieves an improvement in the etch rate of the metal film 96. In the example shown in Fig. 7 as well, the liquid repellency of the interest region 516 of the first electrode 51 (the surface of the liquid-repellent member 512) to the processing liquid L1 suppresses variations in etch width.

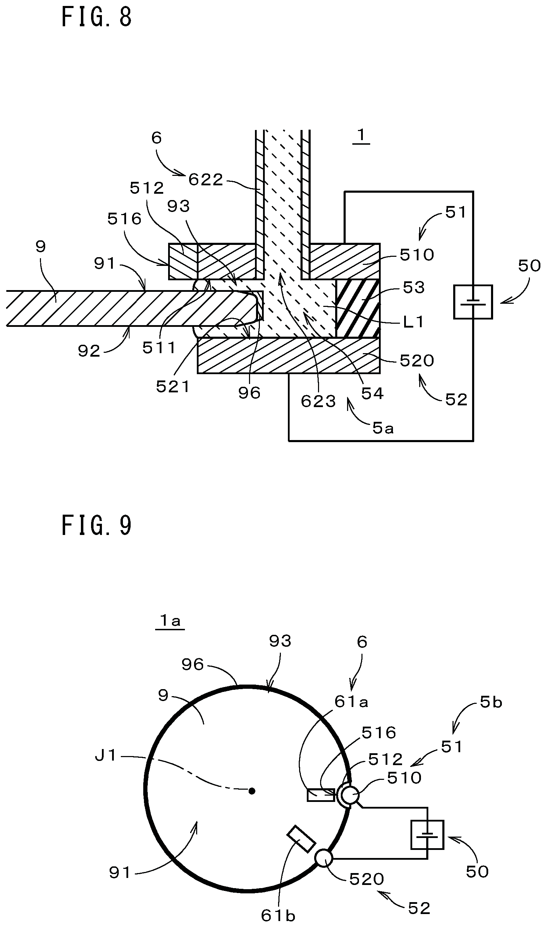

Fig. 8 is a diagram showing another example of the electrode unit. In an electrode unit 5a shown in Fig. 8, the first electrode 51 includes the rectangular plate-like electrode body 510 and the liquid-repellent member 512 mounted on the electrode body 510. The second electrode 52 includes the rectangular plate-like electrode body 520. With the electrode unit 5a arranged at the processing position, the first electrode 51 is located on the side of the first main surface 91 of the substrate 9, and the second electrode 52 is located on the side of the second main surface 92 of the substrate 9. The downward face of the electrode body 510 of the first electrode 51 corresponds to the opposing face 511 facing the substrate 9 and is approximately parallel to the first main surface 91 of the substrate 9. The upward face of the electrode body 520 of the second electrode 52 corresponds to the opposing face 521 facing the substrate 9 and is approximately parallel to the second main surface 92. The opposing face 511 of the electrode body 510 and the opposing face 521 of the electrode body 520 are approximately parallel to each other. The distance between the electrode body 510 and the electrode body 520 is slightly greater than the thickness of the substrate 9.

One side face of each of the electrode bodies 510 and 520 is approximately perpendicular to the radial direction and faces toward the central axis J1. That is, these side faces of the electrode bodies 510 and 520 face radially inward. This side face of the electrode body 510 of the first electrode 51 is covered with the liquid-repellent member 512. In the electrode unit 5a shown in Fig. 8, on the side face of the first electrode 51, the interest region 516 that faces radially inward and that is located in the vicinity of the first main surface 91 is a region on the surface of the liquid-repellent member 512 and has repellency to the processing liquid L1.

The electrode unit 5a further includes an insulating member 53. For example, the insulating member 53 has a block-like shape formed of a resin and is arranged between an outer end portion of the electrode body 510 and an outer end portion of the electrode body 520 in the radial direction. The electrode body 510 and the electrode body 520 are fixedly attached to the insulating member 53. The electrode body 510 has a through hole provided radially inward of the insulating member 53. In the processing liquid line 62 (see Fig. 2) of the processing-liquid filling unit 6, a connecting member 622 is provided on an end portion on the side opposite to the processing-liquid supply source 63, and the connecting member 622 is inserted in and fixedly attached to the aforementioned through hole of the electrode body 510. The connecting member 622 has an ejection port 623 for ejecting the processing liquid L1, and the processing liquid L1 is supplied from the ejection port 623 to a space 54 surround by the insulating member 53, the electrode body 510, and the electrode body 520 (hereinafter, referred to as the "processing space 54"). In the substrate processing apparatus 1 shown in Fig. 8, the connecting member 622, the first electrode 51, the insulating member 53, and the second electrode 52 are integrally configured as a single member. In the supporter 71 (see Fig. 3) of the electrode mover 7, the auxiliary movement mechanism 711 is omitted, and the electrode unit 5a is fixedly attached to the support body 710.

When etching is performed on the peripheral edge portion 93 of the substrate 9, the electrode unit 5a and the connecting member 622 are arranged at the processing position so that the peripheral edge portion 93 is inserted into the processing space 54 from the radially inner side. The processing liquid L1 is ejected from the ejection port 623 of the connecting member 622 so as to fill the processing space 54. That is, a liquid-filled state is formed, in which the processing liquid L1 is filled in the space among the target portion of the peripheral edge portion 93, the first electrode 51, and the second electrode 52. Then, the power source 50 applies a voltage between the first electrode 51 and the second electrode 52 so that the metal film 96 is etched. Moreover, the interest region 516 of the first electrode 51 has repellency to the processing liquid L1. This prevents the occurrence of liquid accumulation on the interest region 516 and suppresses variations in etch width. If the liquid-filled state is maintained in the processing space 54, the processing liquid L1 may be ejected either continuously or intermittently from the ejection port 623.

As described above, the electrode unit 5a shown in Fig. 8 includes the insulating member 53 that is arranged outward of the peripheral edge portion 93 of the substrate 9 and between the first electrode 51 and the second electrode 52 and that is fixedly attached to the first electrode 51 and the second electrode 52. The processing-liquid filling unit 6 supplies the processing liquid L1 from the ejection port 623 to the processing space 54 surrounded by the insulating member 53, the first electrode 51, and the second electrode 52. Accordingly, it becomes possible to form the liquid-filled state with ease and more reliability and to properly perform etching on the metal film 96 on the peripheral edge portion 93.

In the substrate processing apparatus 1, the substrate 9 does not necessarily have to be held in a horizontal position, and for example, may be held in an upright position. In the case where the substrate 9 is held in an upright position in the substrate processing apparatus 1 shown in Fig. 8, the orientation of the electrode unit 5a is changed such that the insulating member 53 is arranged below the substrate 9 in an upright position (in a state obtained by rotating Fig. 8 by 90° in the clockwise direction). In the electrode unit 5a shown in Fig. 8, the first electrode 51 may be located on the side of the first main surface 91 of the substrate 9, and the second electrode 52 may be located radially outward of the substrate 9. As another alternative, the first electrode 51, the insulating member 53, and the second electrode 52 may be arranged side by side in the circumferential direction on the side of the first main surface 91 of the substrate 9. In this case, the radially outer side of the peripheral edge portion 93 and a portion of the peripheral edge portion 93 on the side of the second main surface 92 are covered with another insulating member to form the processing space 54.

Meanwhile, in order to increase the etch rate of the metal film 96 on the peripheral edge portion 93, it is preferable that the first electrode 51 is located on the side of the first main surface 91 of the substrate 9 and the second electrode 52 is located on the side of the second main surface 92 as in the electrode units 5 and 5a shown in Figs. 3, 7, and 8. In this way, arranging the substrate 9 between the first electrode 51 and the second electrode 52 allows efficient etching of the metal film 96. In the above-described electrode units 5 and 5a, the electrode body 510 of the first electrode 51 overlaps almost entirely with the electrode body 520 of the second electrode 52 when viewed in a direction perpendicular to the main surfaces 91 and 92 of the substrate 9. However, the electrode body 510 and the electrode body 520 may overlap only partly with each other. The substrate processing apparatus 1 allows efficient etching of the metal film 96 by causing the first electrode 51 (the electrode body 510 thereof) and the second electrode 52 to overlap at least partly when viewed in a direction perpendicular to the main surfaces 91 and 92 of the substrate 9.

In the above-described substrate processing apparatus 1, the first electrode 51 and the second electrode 52 are arranged at the same circumferential position or at close circumferential positions. However, the first electrode 51 and the second electrode 52 may be separated from each other. Fig. 9 is a diagram showing a substrate processing apparatus 1a according to a second embodiment. In an electrode unit 5a of the substrate processing apparatus 1a, the first electrode 51 includes the electrode body 510 and the liquid-repellent member 512 as in the electrode unit 5. The second electrode 52 includes the second body 520. With the electrode unit 5b arranged at the processing position facing the substrate 9, the first electrode 51 is located in the vicinity of the peripheral edge portion 93 on the side of the first main surface 91. The second electrode 52 is separated from the first electrode 51 in the circumferential direction on the side of the first main surface 91 and is located in the vicinity of the substrate 9. In the example shown in Fig. 9, the second electrode 52 is also located in the vicinity of the peripheral edge portion 93.

The processing-liquid filling unit 6 includes a first processing liquid nozzle 61a and a second processing liquid nozzle 61b that are provided on the side of the first main surface 91. The first processing liquid nozzle 61a is located in the vicinity of the first electrode 51 and ejects the processing liquid L1 toward the gap between the first electrode 51 and the substrate 9. The electrode body 510 is electrically connected via the processing liquid L1 to the metal film 96 on the peripheral edge portion 93. The second processing liquid nozzle 61b is located in the vicinity of the second electrode 52 and ejects the processing liquid L1 toward the gap between the second electrode 52 and the substrate 9. The electrode body 520 is electrically connected via the processing liquid L1 to the metal film 96 on the peripheral edge portion 93 at a different position from the first electrode 51. In this way, the processing-liquid filling unit 6 fills the gaps between the substrate 9 and each of the first electrode 51 and the second electrode 52 with the processing liquid L1 and provides two different (independent) points of contact for the first electrode 51 and the second electrode 52. The other configuration of the substrate processing apparatus 1a is the same as the configuration shown in Fig. 2.

In the etching performed by the substrate processing apparatus 1a as well, the power source 50 applies a voltage between the first electrode 51 and the second electrode 52 while the substrate 9 is being rotated. In the example shown in Fig. 9, the first electrode 51 serves as a cathode, and the second electrode 52 serves as an anode. In this way, the metal film 96 on the peripheral edge portion 93 is etched in the vicinity of the first electrode 51. Moreover, the liquid repellency of the interest region 516 of the first electrode 51 (the surface of the liquid-repellent member 512) to the processing liquid L1 suppresses variations in etch width.

Meanwhile, in the substrate processing apparatus 1a, if the etching process progresses to some extent and the second electrode 52 (anode) faces a region from which the metal film 96 has been removed, the second electrode 52 is not electrically connected to the metal film 96. As a result, no current flows between the first electrode 51 and the second electrode 52, and the etching process ceases to progress. Moreover, in the case where the metal film 96 is scattered on the peripheral edge portion 93, no current flows between the first electrode 51 and the second electrode 52, and the etching process ceases to progress.

In contrast, in the substrate processing apparatus 1 according to the first embodiment, when etching is performed, the first electrode 51 and the second electrode 52 face the target portion that is part of the peripheral edge portion 93 of the substrate 9. Then, the processing liquid L1 is ejected from the ejection port 611 of the processing liquid nozzle 61 (or the ejection port 623 of the connecting member 622) so as to form the liquid-filled state in which the processing liquid L1 is filled in the space among the target portion, the first electrode 51, and the second electrode 52. This allows the first electrode 51 and the second electrode 52 to be electrically connected via the same processing liquid L1, i.e., substantially at a single point of contact, to the metal film 96 on the target portion. As a result, even if there is an isolated metal film 96 or a region from which the metal film 96 has been removed, it is possible to properly perform etching on the metal film 96. Besides, the substrate processing apparatus 1 can significantly reduce the amount of consumption of the processing liquid L1 because the processing liquid L1 is supplied to only one location on the peripheral edge portion 93. Depending on the design of the substrate processing apparatus 1 shown in Fig. 2, another processing liquid nozzle for supplying the processing liquid L1 to the gap between the second electrode 52 and the substrate 9 may be provided in addition to the processing liquid nozzle 61 described above in order to more reliably form the liquid-filled state.

The substrate processing apparatuses 1 and 1a described above may be modified in various ways.

In the case where the end face of the liquid-repellent member 512 of the first electrode 51 on the side of the substrate 9 is located between the substrate 9 and the opposing face 511 of the electrode body 510, a portion of the liquid-repellent member 512 that is located between the substrate 9 and the opposing face 511 may be provided with a plurality of slits each extending in the up-down direction. In this case, the processing liquid L1 ejected from the processing liquid nozzle 61 can enter the gap between the electrode body 510 and the substrate 9 through these slits. Portions of the liquid-repellent member 512 between these slits more reliably suppresses radially inward spread of the processing liquid L1 from the gap.

Varius techniques may be used to fill the gaps between the substrate 9 and each of the first electrode 51 and the second electrode 52 with the processing liquid L1. For example, the processing liquid L1 may be supplied to the side face of the electrode body 510 of the first electrode 51. In this case, the processing liquid L1 flows along the side face, and the processing liquid L1 that has reached the opposing face 511 enters the gap between the opposing face 511 and the substrate 9. The processing liquid L1 flows around to the side of the second main surface 92 and enters the gap between opposing face 521 of the second electrode 52 and the substrate 9. In this way, even if the processing liquid L1 flows along the side face of the electrode body 510, the interest region 516 of the side face of the first electrode 51, which faces radially inward and which is located in the vicinity of the first main surface 91, has repellency to the processing liquid L1. This suppresses variations in etch width due to radially inward spread of the processing liquid L1. In this case, it is preferable that a radially outward region of the side face of the first electrode 51 does not have liquid repellency.

In the substrate processing apparatus 1, the substrate 9 may be held by the substrate holder, with the first main surface 91 where the metal film 96 is formed facing downward. In this case, the electrode facing the first main surface 91 is set to be a first electrode (cathode), and etching is performed on the metal film 96 on the peripheral edge portion 93. Moreover, the interest region of the side face of this electrode has repellency to the processing liquid L1. This suppresses radially inward spread of the processing liquid L1.

The substrate holder that holds the substrate 9 and the rotation mechanism that rotates the substrate 9 may have structures other than the chuck part 21 and the rotation mechanism 22 shown in Fig. 2. For example, a plurality of rollers may be aligned in the circumferential direction around the substrate 9 and hold the substrate 9 in contact with, for example, the edge end face of the substrate 9, and some of the rollers each may rotate on its axis to rotate the substrate 9 about the central axis J1. Depending on the design of the substrate processing apparatus 1, the electrode units 5, 5a, and 5b may rotate about the central axis J1 without rotation of the substrate 9. The rotation mechanism in the substrate processing apparatus 1 may be any mechanism as long as it can rotate the substrate 9 relative to the electrode units 5, 5a, and 5b.

The substrate to be processed by the substrate processing apparatuses 1 and 1a is not limited to a semiconductor substrate, and may be a glass substrate or any other substrate.

The configurations of the above-described preferred embodiment and variations may be appropriately combined as long as there are no mutual inconsistencies.

While the invention has been shown and described in detail, the foregoing description is in all aspects illustrative and not restrictive. It is therefore understood that numerous modifications and variations can be devised without departing from the scope of the invention.

### REFERENCE SIGNS LIST

- 1, 1a: substrate processing apparatus
- 5, 5a, 5b: electrode unit
- 6: processing-liquid filling unit
- 9: substrate
- 21: chuck part
- 22: rotation mechanism
- 50: power source
- 51: first electrode
- 52: second electrode
- 61: processing liquid nozzle
- 73: electrode movement mechanism
- 91: first main surface (of the substrate)
- 92: second main surface (of the substrate)
- 93: peripheral edge portion (of the substrate)
- 96: metal film
- 510: electrode body (of the first electrode)
- 512: liquid-repellent member
- 516: interest region
- 611, 623: ejection port
- L1: processing liquid

## Claims

1. A substrate processing apparatus that performs etching on a peripheral edge portion of a substrate, the substrate processing apparatus comprising:
a substrate holder that holds a substrate, the substrate having a disc-like shape with a first main surface and a second main surface and having a peripheral edge portion on which a metal film is provided on a side of said first main surface;
an electrode unit that includes a first electrode and a second electrode and in which, when etching is performed, said first electrode is located in a vicinity of said peripheral edge portion on a side of said first main surface, and said second electrode is separated from said first electrode and located in a vicinity of said substrate;
a processing-liquid filling unit that fills gaps between said substrate and said first electrode and between said substrate and said second electrode with a processing liquid;
a power source that applies a voltage between said first electrode and said second electrode to allow etching of a portion of said metal film that is located in a vicinity of said first electrode; and
a rotation mechanism that rotates said substrate relative to said electrode unit to move a portion of said peripheral edge portion where etching is performed in a circumferential direction,
wherein said first electrode has a side face including an interest region that has repellency to said processing liquid, the interest region facing radially inward and located in a vicinity of said first main surface.

2. The substrate processing apparatus according to claim 1, in which
said first electrode includes:
an electrode body; and
a liquid-repellent member that covers a region of a side face of said electrode body, the region facing radially inward and located in the vicinity of said first main surface, and
said interest region is included in a surface of said liquid-repellent member.

3. The substrate processing apparatus according to claim 1, wherein
said processing-liquid filling unit includes a processing liquid nozzle that ejects said processing liquid from a radially inner side to a gap between said first electrode and said peripheral edge portion of said substrate.

4. The substrate processing apparatus according to any one of claims 1 to 3, wherein
when etching is performed, said first electrode and said second electrode face a target portion that is part of said peripheral edge portion of said substrate, and
said processing-liquid filling unit forms a liquid-filled state by ejecting said processing liquid from an ejection port, the liquid-filled state being a state in which said processing liquid is filled in a space among said target portion, said first electrode, and said second electrode.

5. The substrate processing apparatus according to claim 4, wherein
said first electrode and said second electrode overlap at least partly when viewed in a direction perpendicular to main surfaces of said substrate.

6. The substrate processing apparatus according to claim 4, further comprising:
an electrode movement mechanism that moves said electrode unit in a radial direction.
